# EUROPÄISCHE PATENTSCHRIFT

(11) **EP 3 635 413 B1**
(45) Veröffentlichungstag und Bekanntmachung des Hinweises auf die Patenterteilung: **23.08.2023**
(21) Anmeldenummer: 18731375.4
(22) Anmeldetag: 05.06.2018
(51) Int. Cl.: G01R 1/067, G01R 1/073, H01R 13/24

(54) **KONTAKTELEMENTSYSTEM**
CONTACT ELEMENT SYSTEM
SYSTÈME À ÉLÉMENTS DE CONTACT

(30) Priorität: 06.06.2017 DE 102017209510
(43) Veröffentlichungstag der Anmeldung: 15.04.2020
(73) Patentinhaber: Feinmetall GmbH, 71083 Herrenberg (DE)
(72) Erfinder: BÖHM, Gunther, 71154 Nufringen (DE); SCHNAITHMANN, Matthias, 71394 Kernen im Remstal (DE); WEILAND, Achim, 68199 Mannheim (DE)
(74) Vertreter: Clarenbach, Carl-Philipp
(86) Internationale Anmeldenummer: PCT/EP2018/064683
(87) Internationale Veröffentlichungsnummer: WO 2018/224458

(56) Entgegenhaltungen:
- DE-A1-102008 023 761
- US-A1- 2011 062 978

## Beschreibung

Die Erfindung betrifft ein Kontaktelementsystem mit einer Vielzahl von gleich langen, nadelförmigen oder stiftförmigen, insbesondere streifenförmigen, und elektrisch leitfähigen Kontaktelementen, die jeweils zwei Endbereiche zum elektrischen Berührungskontaktieren von Kontaktstellen sowie jeweils einen zwischen den Endbereichen liegenden Zwischenbereich aufweisen, wobei die Kontaktelemente jeweils in dem Zwischenbereich bei einer Belastung in ihrer Längserstreckung elastisch unter Überwindung ihrer Biegesteifigkeit zumindest bogenförmig auslenkbar und dazu in dem Zwischenbereich derart lamelliert ausgebildet sind, dass sie zumindest zwei parallel zueinander und beabstandet voneinander verlaufende Lamellen aufweisen.

Kontaktelementsysteme der eingangs genannten Art sind aus dem Stand der Technik bekannt. Zur Durchführung einer elektrischen Prüfung eines elektrischen Prüflings ist es bekannt, die elektrisch leitfähigen Kontaktstellen des Prüflings berührungszukontaktieren und mit einem elektrischen Strom und/oder einer elektrischen Spannung zu beaufschlagen, um die Funktionsfähigkeit des Prüflings zu erfassen. Für die Berührungskontaktierung ist es bekannt, einen Kontaktkopf einzusetzen, in welchem eine Vielzahl von Kontaktelementen gehalten sind, die einendig die Kontaktstellen des Prüflings kontaktieren. Um zu gewährleisten, dass alle Kontaktstellen des Prüflings sicher berührungskontaktiert werden können, sind die Kontaktelemente derart ausgebildet, dass sie einfedern können, um Höhenunterschiede der Kontaktstellen ausgleichen und damit das Berührungskontaktieren aller Kontaktstellen gewährleisten können. Neben dem Vorsehen von Federkontaktstiften, die mehrteilig aufgebaut sind, ist es auch bekannt, einstückige Kontaktelemente in Form von sogenannten Kontakt- oder Knicknadeln zu verwenden, die sich dadurch auszeichnen, dass sie seitlich - in Bezug auf ihre Längserstreckung - ausgelenkt werden können, wenn sie in Richtung ihrer Längserstreckung mit einer Kraft (Kontaktkraft) beaufschlagt werden. Optional weisen diese Art von Kontaktelemente auch im nicht-belasteten Zustand einen bogenförmigen oder S-förmigen Abschnitt auf, sodass das Auslenken bei einer Belastung in Längserstreckung stets möglich ist. Weil im Prüfbetrieb eine Vielzahl von Berührungskontaktierungen erfolgt, die Kontaktelemente also häufig belastet und ausgelenkt werden, ist die Dauerhaltbarkeit und Belastbarkeit der Kontaktelemente von hohem Interesse. Um eine sichere Berührungskontaktierung und gleichzeitig ein sicheres Auslenken der Kontaktelemente zu gewährleisten, sind mittlerweile Kontaktelemente bekannt, wie beispielsweise aus der Offenlegungsschrift DE 10 2008 023 761 A1, welche in einem zwischen den Endbereichen des jeweiligen Kontaktelements liegenden Zwischenbereich aufweisen, der lamelliert ausgebildet ist. Dazu weist dieser Zwischenbereich zwei oder mehr Lamellen auf, die sich in Längserstreckung des Kontaktelements erstrecken und zumindest im Wesentlichen parallel zueinander verlaufen. Dabei sind die Lamellen seitlich beabstandet zueinander ausgebildet. Durch diese Art der Kontaktelemente wird die Kraft, die zum Auslenken des jeweiligen Kontaktelements benötigt wird, reduziert, ohne dass die Funktion des Kontaktelements beeinträchtigt wird.

Dabei ist zu berücksichtigen, dass die Oberfläche der Kontaktstellen nicht oder nur geringfügig beschädigt wird, um nach dem Einbau des Prüflings in ein Gerät keine Zuverlässigkeitsprobleme zu erhalten. Daher ist man bestrebt, die geringstmögliche Kontaktkraft, also die senkrecht auf die Kontaktstelle wirkende Kraft, die in Längsrichtung des Kontaktelements wirkt, vorzusehen. Dem steht jedoch entgegen, dass mit höherer Kontaktkraft eine zuverlässigere Kontaktierung erreichbar ist. Bei der Konfiguration von Testanordnungen wird aus diesem Zielkonflikt ein Kompromiss beziehungsweise eine optimale Kontaktkraft abgeleitet, die einerseits gerade noch eine akzeptable Schädigung verursacht und andererseits eine verlässliche Testdurchführung ermöglicht. Diese Kontaktkraft soll bei allen verwendeten Kontakten der Kontaktanordnung beziehungsweise allen Kontaktstellen des Prüflings in gleicher Art wirken, um ein vorteilhaftes Ergebnis zu erreichen.

Die Art der Kontaktstellen unterscheiden sich jedoch voneinander, so kann beispielsweise eine erste Gruppe von Kontaktstellen dazu genutzt werden, analoge oder digitale Signale zu übertragen und andere Kontaktstellen werden zur Stromversorgung des Prüflings genutzt. Damit unterscheiden sich die Anforderungen an die Kontaktelemente, die selbst als elektrischer Leiter wirken beziehungsweise genutzt werden. Es ist daher von Vorteil, wenn die Kontaktelemente auf ihre jeweilige elektrische Funktion optimierbar sind, beispielsweise für eine Stromversorgung mit einem großen Leitungsquerschnitt oder für eine Signalübertragung mit einem kleinen Leitungsquerschnitt, auch um einen vorhandenen Bauraum optional ausnutzen zu können.

Kontaktelemente mit Lamellen in einem Zwischenbereich sind beispielsweise aus der Offenlegungsschrift DE 10 2008 023 761 A1 sowie aus US 2011/062978 A1 bereits bekannt.

Der Erfindung liegt daher die Aufgabe zugrunde, ein Kontaktsystem zu schaffen, das einerseits eine vorteilhafte mechanische Berührungskontaktierung der Kontaktstellen des Prüflings erlaubt, und andererseits an die elektrischen Anforderungen des Prüflings optimal angepasst ist.

Die der Erfindung zugrundeliegende Aufgabe wird durch ein Kontaktelementsystem mit den Merkmalen des Anspruchs 1 gelöst. Dieses hat den Vorteil, dass die Kontaktelemente die gleichen mechanischen Eigenschaften in Bezug auf die Kontaktkraft beziehungsweise Biegesteifigkeit aufweisen, jedoch unterschiedliche elektrische Widerstände beziehungsweise unterschiedliche elektrische Eigenschaften bieten. Dabei sind die Kontaktelemente zweckmäßigerweise aus dem gleichen Material gefertigt, sodass sich die Unterschiede nicht aus der Materialwahl ergeben, was grundsätzlich ebenfalls möglich wäre. Vielmehr ist erfindungsgemäß jedoch vorgesehen, dass zumindest zwei der Kontaktelemente in dem Zwischenbereich unterschiedliche Querschnittsflächen und unterschiedlich geformte Lamellen aufweisen, wobei die Formen der Lamellen derart gewählt sind, dass die zumindest zwei Kontaktelemente die gleiche Biegesteifigkeit aufweisen. Dadurch, dass die Kontaktelemente die gleiche Biegesteifigkeit aufweisen, sind die Kontaktkräfte, die auf die jeweiligen Kontaktstellen des Prüflings wirken, die gleichen. Aufgrund der unterschiedlich großen Querschnittsflächen der Kontaktelemente im Zwischenbereich, werden jedoch unterschiedliche elektrische Eigenschaften der Kontaktelemente aufgrund des sich jeweils durch die Querschnittsfläche ergebenden elektrischen Gesamtwiderstands geboten. Bei der Montage einer Testanordnung aus diesem Kontaktelementsystem ist eine Auswahl von Kontaktelementen wählbar, die elektrisch optimal für die jeweilige Testaufgabe ausgebildet sind und außerdem die gleiche Biegesteifigkeit und damit die gleiche Kontaktkraft bei Durchführung eines Berührungskontakts aufweisen.

Insbesondere ist vorgesehen, dass die Lamellen der zumindest zwei Kontaktelemente unterschiedlich lang ausgebildet sind, die Formen der Lamellen der zumindest zwei Kontaktelemente unterscheiden sich somit in der Länge der Lamellen. Mit zunehmender Länge der Lamellen nimmt die Biegesteifigkeit der Kontaktelemente ab. Daher weist das Kontaktelement mit den längeren Lamellen bevorzugt eine Querschnittsform im Zwischenbereich auf, welche die Biegesteifigkeit erhöht und dadurch die größere Lamellenlänge kompensiert. Andersherum wird beispielsweise bei dem einen Kontaktelement eine kleinere Gesamtquerschnittsfläche gewählt, die die Biegesteifigkeit des Kontaktelements ebenfalls reduziert, und zum Erreichen der gleichen Biegesteifigkeit bei einem anderen Kontaktelement werden die Lamellen verlängert. Dadurch kann insgesamt bei beiden Kontaktelementen die gleiche Biegesteifigkeit bei unterschiedlichen elektrischen Eigenschaften erreicht werden.

Weiterhin ist bevorzugt vorgesehen, dass die Lamellen der zumindest zwei Kontaktelemente unterschiedlich tief ausgebildet sind. Unter der Tiefe wird hierbei die Erstreckung der Lamellen beziehungsweise der Kontaktelemente senkrecht zur Längserstreckung und senkrecht zur Biegerichtung verstanden. Durch die unterschiedlich tief ausgebildeten Lamellen ergeben sich unterschiedliche Biegesteifigkeiten, wobei die Biegesteifigkeit mit zunehmender Tiefe aufgrund der Materialzunahme zunimmt.

Ferner ist bevorzugt vorgesehen, dass die Lamellen der zumindest zwei Kontaktelemente unterschiedlich breit ausgebildet sind. Unter der Breite der Lamellen wird dabei die Erstreckung der Lamellen senkrecht zur Längserstreckung und senkrecht zur Tiefe verstanden, also die Erstreckung, die in der Ebene liegt, in welcher die Lamellen bei einer Berührungskontaktierung ausgelenkt werden. Mit zunehmender Breite nimmt auch die Biegesteifigkeit der Lamellen und damit des jeweiligen Kontaktelements zu. In diesem Fall können beispielsweise die breiten Lamellen des einen Kontaktelements durch kürzere Lamellen des anderen Kontaktelements zum Erreichen der gleichen oder nahezu gleichen Biegesteifigkeit kompensiert werden, um bei beiden Kontaktelementen die gleiche Biegesteifigkeit zu erhalten.

Gemäß einer bevorzugten Weiterbildung der Erfindung ist vorgesehen, dass zumindest zwei der Lamellen der zumindest zwei Kontaktelemente unterschiedliche Querschnittsformen aufweisen. Auch die Querschnittsform der jeweiligen Lamelle beeinflusst die Biegesteifigkeit. So können die Lamellen beispielsweise einen dreieckförmigen, rechteckförmigen, kreisförmigen, ovalförmigen oder allgemein mehreckförmigen Querschnitt aufweisen.

Vorzugsweise weisen die zumindest zwei Kontaktelemente eine unterschiedliche Anzahl von Lamellen auf. So wird beispielsweise die durch eine erhöhte Tiefe erhöhte Biegesteifigkeit des einen Kontaktelements durch eine zusätzliche Lamelle des weiteren Kontaktelements kompensiert, um die gleiche Biegesteifigkeit zu erhalten.

Vorzugsweise weist ein erstes der Kontaktelemente eine erste Anzahl von Lamellen mit einer ersten Gesamtquerschnittsfläche (=Summe der Querschnittsflächen aller Lamellen des Kontaktelements) auf, und ein zweites der Kontaktelemente eine zweite Anzahl von Lamellen mit einer zweiten Gesamtquerschnittsfläche, wobei die erste Anzahl größer ist als die zweite Anzahl und die jeweils erste Gesamtquerschnittsfläche größer als die zweite. Hierdurch ergibt sich im Endeffekt, dass beide Kontaktelemente die gleiche Biegesteifigkeit aufweisen, obwohl sie aufgrund der reduzierten Gesamtquerschnittsfläche des zweiten Kontaktelements unterschiedliche elektrische Widerstände beziehungsweise Leitungsquerschnitte aufweisen.

Besonders bevorzugt ist die Tiefe der Lamellen des ersten Kontaktelements größer als die des zweiten, um die Anzahl der Lamellen des ersten Kontaktelements gering zu halten, bei gleichbleibender Biegesteifigkeit. Weiterhin ist bevorzugt vorgesehen, dass die Länge der Lamellen in dieser Ausführungsform länger ist als die Länge der Lamellen des zweiten Kontaktelements, um die Biegesteifigkeit gleich zu halten, mit der Folge, dass beispielsweise die Querschnittsfläche der ersten Lamellen im Gegenzug erhöht werden kann.

Gemäß einer bevorzugten Ausführungsform der Erfindung ist vorgesehen, dass das Kontaktelementsystem eine Vielzahl der ersten und der zweiten Kontaktelemente aufweist. Optional weist das Kontaktelementsystem mehr als zwei unterschiedliche Kontaktelemente auf, die die oben genannten Anforderungen erfüllen.

Weitere Vorteile und bevorzugte Merkmale und Merkmalskombinationen ergeben sich aus dem zuvor Beschriebenen sowie aus den Ansprüchen.

Im Folgenden soll die Erfindung anhand der Zeichnung näher erläutert werden. Dazu zeigen
- Figur 1: eine vereinfachte Darstellung eines Kontaktmusters einer Kontaktanordnung,
- Figur 2: einen Kontaktkopf einer Prüfeinrichtung in einer Schnittdarstellung,
- Figur 3: eine Detailschnittdarstellung des Prüfkopfs und
- Figur 4: eine weitere Detailschnittdarstellung des Prüfkopfs.

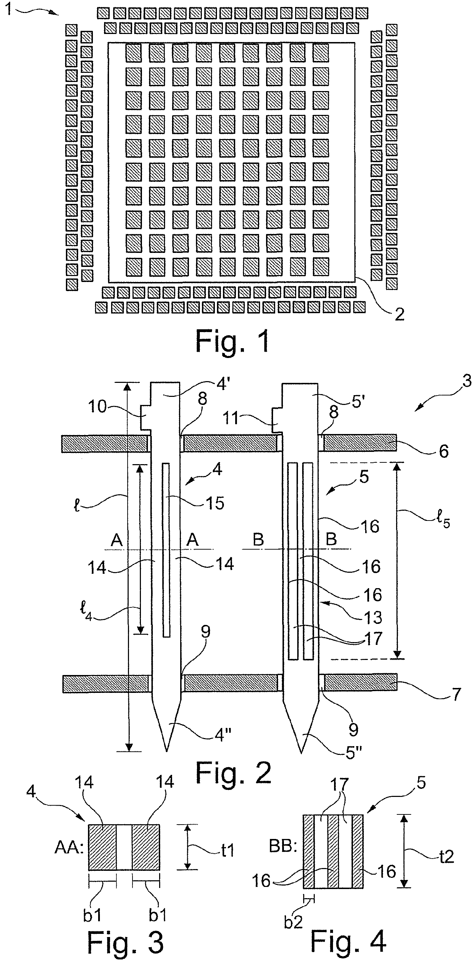

Figur 1 zeigt in einer vereinfachten Draufsicht das Muster einer Kontaktanordnung 1 für einen elektrischen Prüfling, der eine Vielzahl von elektrisch leitfähigen Kontaktstellen aufweist, die durch eine Prüfeinrichtung berührungskontaktiert werden sollen und vorliegend als Kästchen dargestellt sind. In einem mittleren Bereich, der vorliegend durch ein Kasten 2 gekennzeichnet ist, sind dabei Kontaktstellen vorgesehen, die zur Durchführung der Prüfung oder zur Stromversorgung des Prüflings mit einem hohen Strom beaufschlagt werden (größere Kästchen), während in dem außerhalb des Kastens 2 liegenden Bereich Kontaktstellen vorliegen, die mit einem vergleichsweise dazu niedrigeren Strom insbesondere zur Signalübertragung beaufschlagt werden (kleinere Kästchen). Dies ergibt sich beispielsweise dadurch, dass die innenliegenden Kontaktstellen stromführende Kontaktstellen sind, während die außenliegenden Kontaktstellen allein Signalkontaktstellen zur Übermittlung analoger oder digitaler Signale sind.

Zur Kontaktierung der unterschiedlichen Kontaktstellen weist die Prüfeinrichtung 1 vorteilhafterweise einen Kontaktkopf 3 auf, der unterschiedlich geartete Kontaktelemente 4, 5 trägt, die zur elektrischen Berührungskontaktierung der unterschiedlichen Kontaktstellen optimiert ausgebildet sind.

Figur 2 zeigt hierzu in einer vereinfachten Schnittdarstellung den Kontaktkopf 3. Dieser weist zwei parallel zueinander und beabstandet zueinander angeordnete Führungsplatten 6, 7 auf, in welchen eine Vielzahl von Führungsöffnungen 8 beziehungsweise 9 ausgebildet sind. Die Führungsöffnungen 8, 9 sind dabei jeweils matrixförmig in den Führungsplatten 6, 7 verteilt angeordnet, beispielsweise gemäß der Kontaktanordnung 1 der Kontaktstellen, wie sie in Figur 1 gezeigt ist.

Die Führungsöffnungen 8, 9 der beiden Führungsplatten 6, 7 sind entweder fluchtend oder lateral versetzt zueinander angeordnet, wobei jeweils ein Kontaktelement jeweils einer der Führungsöffnungen der beiden Platten 6, 7 geführt ist.

Die Kontaktelemente 4, 5 sind dabei als stift- beziehungsweise nadelförmige Kontaktelemente 4, 5 ausgebildet, die die gleiche Länge 1 aufweisen. Ihre Endbereiche dienen als Kontaktstellen zur Berührungskontaktierung der Kontaktelemente des Prüflings oder der übergeordneten Prüfeinrichtung, welche den Test durchführt und die Kontaktelemente 4, 5 mit einem Strom oder einer Spannung beaufschlagt oder beispielsweise Stromsignale empfängt. An ihrem oberen Endbereich 4' beziehungsweise 5' weisen die Kontaktelemente 4, 5 optional jeweils einen seitlichen Vorsprung 10 beziehungsweise 11 auf, der ein Durchrutschen der Kontaktelemente 4, 5 durch die jeweilige Führungsöffnung 8 der Führungsplatte 6 verhindert. In einem zwischen den Endbereichen 4', 5' und 4", 5" liegenden Zwischenbereich 12 beziehungsweise 13 sind die Kontaktelemente 4, 5 lamelliert ausgebildet.

In diesem Fall weist das in der Figur 2 linke Kontaktelement 4 zwei Lamellen 14 auf, die parallel zueinander verlaufen und durch einen Schlitz 15 beabstandet zueinander sind. Die Lamellen 14 und der Schlitz 15 verlaufen dabei in Längserstreckung des Kontaktelements 4.

Im Unterschied dazu weist das Kontaktelement 5 drei Lamellen 16 auf, die durch zwei Schlitze 17 voneinander getrennt sind. Auch diese Lamellen 16 verlaufen parallel zueinander in Längserstreckung des Kontaktelements 5.

Figur 3A zeigt ein Querschnitt durch das Kontaktelement 4 im Zwischenbereich gemäß der Linie A-A. Hierbei ist zu sehen, dass die Lamellen 14 eine Tiefe t1 aufweisen, die größer ist als ihre jeweilige Breite b1.

Figur 4 zeigt ein Querschnitt durch das Kontaktelement 5 entlang der Linie B-B aus Figur 2. Es ist ersichtlich, dass das Kontaktelement 5 und damit seine Lamellen 16 eine im Vergleich zur Tiefe t1 des Kontaktelements 4 größere Tiefe t2 aufweisen. Gleichzeitig weisen die einzelnen Lamellen 16 eine kleinere Breite b2 auf. Außerdem sind die Lamellen 16 beziehungsweise die Schlitze 17, wie in Figur 2 ersichtlich, länger ausgebildet und weisen also auch eine größere Länge l₅ als die Lamellen 14 beziehungsweise der Schlitz 15, die eine entsprechend kleinere Länge l₄ aufweisen.

Insgesamt ergibt sich jedoch durch die vorteilhafte Ausbildung der Lamellen 14, 16 beziehungsweise der Zwischenbereiche 12 und 13, dass beide Kontaktelemente 4, 5 die gleiche Biegesteifigkeit, jedoch unterschiedliche Gesamtquerschnittsflächen, die sich aus den Querschnittsflächen der einzelnen Lamellen 14, 16 ergeben, aufweisen.

Bei einem Berührungskontaktiervorgang werden die Kontaktelemente 4, 5 entlang ihrer Längserstreckung mit einer Kontaktkraft axial beaufschlagt. Dadurch können die Kontaktelemente 5 im Zwischenbereich 12, 13 seitlich ausgelenkt werden, sodass die Kontaktenden 4" und 5" in Richtung der Kontaktenden 4' und 5' einfedern können. Die Biegesteifigkeit definiert dabei die dafür aufzubringende Axialkraft, die notwendig ist, um das Auslenken zu bewirken. Durch die vorteilhafte Ausgestaltung und die gleiche Biegesteifigkeit ist somit die gleiche Kontaktkraft notwendig, um ein Auslenken/Einfedern zu erreichen. Dadurch ist die Kraft, die durch die Kontaktelemente 4, 5 auf die Kontaktstellen des Prüflings ausgeübt wird, ebenfalls gleich oder nahezu gleich und führt zu keinen oder vernachlässigbaren Beschädigungen der Kontaktstellen, bei gleichzeitig ausreichender Kontaktiersicherheit.

Weil außerdem die Querschnittsflächen der Lamellen 14, 16 aufgrund der unterschiedlichen Breite, Tiefe und Anzahl der Lamellen 14, 16 unterschiedlich gewählt ist, ergeben sich unterschiedliche elektrische Leitungsquerschnitte beziehungsweise Widerstände der Kontaktelemente 4, 5, die dazu führen, dass beispielsweise durch die Kontaktelemente 4, 5 unterschiedlich hohe Ströme geführt werden, auch wenn die gleiche Spannung anliegt. Dadurch ist eine vorteilhafte Durchführung der Berührungskontaktierung und des Testens des Prüflings gewährleistet.

Für jede der außenliegenden Kontaktstellen gemäß dem Kontaktmuster 1 aus Figur 1, ist dabei vorliegend jeweils eines der Kontaktelemente 4 vorgesehen und für die jeweils innenliegenden Kontaktstellen jeweils ein Kontaktelement 5. Dadurch ist ein Kontaktelementsystem aus unterschiedlichen Kontaktelementen 4, 5 geboten, die die gleiche oder nahezu Biegesteifigkeit und damit die gleiche Kontaktkraft aufweisen, jedoch unterschiedliche Leitungsquerschnitte beziehungsweise Gesamtquerschnittsflächen zur Verfügung stellen. Optional kann das Kontaktelementsystem auch noch weitere Kontaktelemente aufweisen, die einen anderen Leitungsquerschnitt bei gleicher Biegesteifigkeit/Kontaktkraft bieten, sodass das Kontaktelementsystem beispielsweise drei oder mehr unterschiedliche Kontaktelemente aufweist, die die gleiche oder nahezu gleiche Kontaktkraft/Biegesteifigkeit gewährleisten.

## Patentansprüche

1. Kontaktelementsystem mit einer Vielzahl von gleich langen, stift- oder nadelförmigen und elektrisch leitfähigen Kontaktelementen (4,5), die jeweils zwei Endbereiche (4`,5 `,4",5 ") zum elektrischen Berührungskontaktieren von Kontaktstellen sowie jeweils einen zwischen den jeweiligen Endbereichen liegenden Zwischenbereich (12,13) aufweisen, wobei die Kontaktelemente (4,5) jeweils in dem Zwischenbereich (12,13) bei einer Belastung in ihrer Längserstreckung elastisch unter Überwindung ihrer Biegesteifigkeit bogenförmig auslenkbar und dazu in dem jeweiligen Zwischenbereich (12,13) derart lamelliert ausgebildet sind, dass sie jeweils zumindest zwei parallel zueinander und beabstandet voneinander verlaufende Lamellen (14,16) aufweisen, **dadurch gekennzeichnet, dass** zumindest zwei Kontaktelemente (4,5) aus der Vielzahl von Kontaktelementen (4,5) in ihren Zwischenbereichen (12,13) im Vergleich der Zwischenbereiche (12,13) miteinander unterschiedliche Querschnittsflächen und unterschiedlich geformte Lamellen aufweisen, wobei die Formen der Lamellen (14,16) derart gewählt sind, dass die zumindest zwei Kontaktelemente (4,5) die gleiche Biegesteifigkeit aufweisen.

2. Kontaktelementsystem nach Anspruch 1, **dadurch gekennzeichnet, dass** die Lamellen (14,16) der zumindest zwei Kontaktelemente (4,5) im Vergleich der Zwischenbereiche (12,13) der zumindest zwei Kontaktelemente (4,5) miteinander unterschiedlich lang ausgebildet sind.

3. Kontaktelementsystem nach einem der vorhergehenden Ansprüche, **dadurch gekennzeichnet, dass** die Lamellen (14,16) der zumindest zwei Kontaktelemente (4,5) im Vergleich der Zwischenbereiche (12,13) der zumindest zwei Kontaktelemente (4,5) miteinander unterschiedlich tief ausgebildet sind.

4. Kontaktelementsystem nach einem der vorhergehenden Ansprüche, **dadurch gekennzeichnet, dass** die Lamellen (14,16) der zumindest zwei Kontaktelemente (4,5) im Vergleich der Zwischenbereiche (12,13) der zumindest zwei Kontaktelemente (4,5) miteinander unterschiedlich breit ausgebildet sind.

5. Kontaktelementsystem nach einem der vorhergehenden Ansprüche, **dadurch gekennzeichnet, dass** zumindest zwei der Lamellen (14,16) der zumindest zwei Kontaktelemente (4,5) im Vergleich der Zwischenbereiche (12,13) der zumindest zwei Kontaktelemente (4,5) miteinander unterschiedliche Querschnittsformen aufweisen.

6. Kontaktelementsystem nach einem der vorhergehenden Ansprüche, **dadurch gekennzeichnet, dass** die zumindest zwei Kontaktelemente (4,5) im Vergleich der Zwischenbereiche der zumindest zwei Kontaktelemente (4,5) miteinander eine unterschiedliche Anzahl von Lamellen (14,16) aufweisen.

7. Kontaktelementsystem nach einem der vorhergehenden Ansprüche, **dadurch gekennzeichnet, dass** ein erstes der Kontaktelemente (5) eine erste Anzahl von Lamellen (16) mit einer ersten Gesamtquerschnittsfläche aufweist, und ein zweites der Kontaktelemente (4) eine zweite Anzahl von Lamellen (14) mit einer zweiten Gesamtquerschnittsfläche, wobei die erste Anzahl größer als die zweite Anzahl und die erste Gesamtquerschnittsfläche größer als die zweite ist.

8. Kontaktelementsystem nach Anspruch 7, **dadurch gekennzeichnet, dass** die Tiefe (t2) der Lamellen (16) des ersten Kontaktelements (4) größer ist als die des zweiten.

9. Kontaktelementsystem nach einem der Ansprüche 7 oder 8, **dadurch gekennzeichnet, dass** die Länge (l₅) der Lamellen (16) des ersten Kontaktelements (5) länger ist als die Länge (l₄) der Lamellen (14) des zweiten Kontaktelements (4).

10. Kontaktelementsystem nach einem der Ansprüche 7 bis 9, **dadurch gekennzeichnet, dass** mehrere erste Kontaktelemente (5) und mehrere zweite Kontaktelemente (4) vorhanden sind.

## Claims

1. Contact element system having a plurality of identically long, pin-shaped or needle-shaped and electrically conductive contact elements (4,5), each having two end regions (4',5' ,4", 5") for electrically contacting contact positions and each having an intermediate region (12,13) between the end regions, wherein the contact elements (4,5) are formed so that each are elastically bendable in the intermediate region (12,13) in their longitudinal extension when a load is applied, overcoming their bending rigidity, and to this purpose, each have a lamellar shape in the intermediate region (12,13) such that each comprises at least two strips (14,16) that run parallel to each other and are spaced from each other, **characterized in that** at least two of contact elements (4,5) of the plurality of contact elements (4,5), comparing the intermediate regions (12,13) of the at least wo contact elements (4,5) with each other, comprise different cross-section areas and differently shaped strips in their intermediate areas (12,13), wherein the shapes of the strips (14,16) being chosen so that the contact elements (4,5) have the same or almost the same bending rigidity.

2. Contact element system according to claim 1, **characterized in that** the strips (14,16) of the at least two contact elements (4,5), comparing the intermediate regions (12,13) of the at least two contact elements (4,5) with each other, are of a different length.

3. Contact element system according to any one of the preceding claims, **characterized in that** the strips (14,16) of the at least two contact elements (4,5), comparing the intermediate regions (12,13) of the at least two contact elements (4,5) with each other, are of a different depth.

4. Contact element system according to any one of the preceding claims, **characterized in that** the strips (14,16) of the at least two contact elements (4,5), comparing the intermediate regions (12,13) of the at least two contact elements (4,5) with each other, are of a different width.

5. Contact element system according to any one of the preceding claims, **characterized in that** at least two of the strips (14,16) of the at least two contact elements (4,5), comparing the intermediate regions (12,13) of the at least two contact elements (4,5) with each other, have different cross-sectional shapes.

6. Contact element system according to any one of the preceding claims, **characterized in that** the at least two contact elements (4,5), comparing the intermediate regions (12,13) of the at least two contact elements (4,5) with each other, have a different number of strips (14,16).

7. Contact element system according to any one of the preceding claims, **characterized in that** a first of the contact elements (5) comprises a first number of strips (16) with a first total cross-sectional area, and a second of the contact elements (4) comprises a second number of strips (14) with a second total cross-sectional area, wherein the first number is greater than the second number and the first total cross-sectional area is greater than the second.

8. Contact element system according to claim 7, **characterized in that** the depth (t2) of the strips (16) of the first contact element (4) is greater than that of the second.

9. Contact element system according to any one of claims 7 or 8, **characterized in that** the length (l₅) of the strips (16) of the first contact element (5) is greater than the length (14) of the strips (14) of the second contact element (4).

10. Contact element system according to one of the preceding claims, **characterized in that** a plurality of first contact elements (5) and a plurality of second contact elements (4) are present.

## Revendications

1. Système à éléments de contact ayant une pluralité à éléments de contact (4, 5) de même longueur, en forme de broche ou d'aiguille et électriquement conducteurs, qui présentent chacun deux zones d'extrémité (4', 5', 4", 5") pour la mise en contact électrique par contact de points de contact ainsi qu'une zone intermédiaire (12, 13), les éléments de contact (4, 5) pouvant être déviés élastiquement sous forme d'arc dans la zone intermédiaire (12, 13) lors d'une sollicitation dans leur extension longitudinale en surmontant leur rigidité à la flexion et étant à cet effet disposés dans la zone intermédiaire (12, 13) respective, de telle sorte qu'ils présentent chacun au moins deux lamelles (14, 16) s'étendant parallèlement l'une à l'autre et à distance l'une de l'autre, **caractérisé en ce qu'**au moins deux éléments de contact (4, 5) de la pluralité à éléments de contact (4, 5) présentent dans leurs zones intermédiaires (12, 13), en comparaison des zones intermédiaires (12, 13), des surfaces de section transversale différentes et des lamelles de formes différentes, les formes des lamelles (14, 16) étant choisies de telle sorte que les au moins deux éléments de contact (4, 5) présentent la même résistance à la flexion.

2. Système à éléments de contact selon la revendication 1, **caractérisé en ce que** les lamelles (14, 16) des au moins deux éléments de contact (4, 5) sont de longueurs différentes en comparaison des zones intermédiaires (12, 13) des au moins deux éléments de contact (4, 5) entre eux.

3. Système à éléments de contact selon l'une des revendications précédentes, **caractérisé en ce que** les lamelles (14, 16) des au moins deux éléments de contact (4, 5) sont formées à des profondeurs différentes en comparaison des zones intermédiaires (12, 13) des au moins deux éléments de contact (4, 5) entre eux.

4. Système à éléments de contact selon l'une des revendications précédentes, **caractérisé en ce que** les lamelles (14, 16) des au moins deux éléments de contact (4, 5) sont de largeurs différentes en comparaison des zones intermédiaires (12, 13) des au moins deux éléments de contact (4, 5) entre eux.

5. Système à éléments de contact selon l'une quelconque des revendications précédentes, **caractérisé en ce qu'**au moins deux des lamelles (14, 16) desdits au moins deux éléments de contact (4, 5) présentent des formes de section transversale différentes l'une de l'autre en comparaison des zones intermédiaires (12, 13) desdits au moins deux éléments de contact (4, 5).

6. Système à éléments de contact selon l'une des revendications précédentes, **caractérisé en ce que** les au moins deux éléments de contact (4, 5) présentent un nombre différent de lamelles (14, 16) en comparaison des zones intermédiaires des au moins deux éléments de contact (4, 5) entre eux.

7. Système à éléments de contact selon l'une quelconque des revendications précédentes, **caractérisé en ce qu'**un premier des éléments de contact (5) comprend un premier nombre de lamelles (16) ayant une première surface totale de section transversale, et qu'un deuxième des éléments de contact (4) comprend un deuxième nombre de lamelles (14) ayant une deuxième surface totale de section transversale, le premier nombre étant supérieur au deuxième nombre et la première surface totale de section transversale étant supérieure à la deuxième.

8. Système à éléments de contact selon la revendication 7, **caractérisé en ce que** la profondeur (t2) des lamelles (16) du premier élément de contact (4) est supérieure à celle du second.

9. Système à éléments de contact selon l'une des revendications 7 ou 8, **caractérisé en ce que** la longueur (15) des lamelles (16) du premier élément de contact (5) est supérieure à la longueur (14) des lamelles (14) du deuxième élément de contact (4).

10. Système à éléments de contact selon l'une des revendications 7 à 9, **caractérisé en ce qu'**il existe plusieurs premiers éléments de contact (5) et plusieurs deuxièmes éléments de contact (4).
